(19) Europäisches Patentamt / European Patent Office / Office européen des brevets

(11) **EP 3 714 485 B1**

(12) **EUROPÄISCHE PATENTSCHRIFT**

(45) Veröffentlichungstag und Bekanntmachung des Hinweises auf die Patenterteilung:
**23.06.2021 Patentblatt 2021/25**

(21) Anmeldenummer: **19706539.4**

(22) Anmeldetag: **18.02.2019**

(51) Int Cl.:
*H01L 23/373* *(2006.01)*    *H01L 21/00* *(2006.01)*
*H01L 25/00* *(2006.01)*    *C04B 37/02* *(2006.01)*

(86) Internationale Anmeldenummer:
**PCT/EP2019/053971**

(87) Internationale Veröffentlichungsnummer:
**WO 2019/166259 (06.09.2019 Gazette 2019/36)**

(54) **METALL-KERAMIK-SUBSTRAT UND VERFAHREN ZUM HERSTELLEN EINES METALL-KERAMIK-SUBSTRATS**

METAL-CERAMIC SUBSTRATE AND ITS MANUFACTURING METHOD

SUBSTRAT MÉTAL-CÉRAMIQUE ET SA MÉTHODE DE FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.02.2018 DE 102018104521**

(43) Veröffentlichungstag der Anmeldung:
**30.09.2020 Patentblatt 2020/40**

(73) Patentinhaber: **Rogers Germany GmbH**
**92676 Eschenbach (DE)**

(72) Erfinder:
• **MEYER, Andreas**
**93173 Wenzenbach (DE)**
• **BRITTING, Stefan**
**91220 Schnaittach (DE)**

(74) Vertreter: **Müller Schupfner & Partner**
**Patent- und Rechtsanwaltspartnerschaft mbB**
**Bavariaring 11**
**80336 München (DE)**

(56) Entgegenhaltungen:
**EP-A1- 1 909 321        EP-A1- 3 248 956**
**WO-A1-2017/056666     DE-A1-102007 030 389**
**JP-A- 2012 023 404      US-A1- 2012 114 966**
**US-A1- 2017 151 755**

• **Bernd Lehmeier ET AL: "Curamik ceramic substrate - DBC technology - Design rules", , 1. April 2014 (2014-04-01), XP055583191, Gefunden im Internet: URL:https://www.rogerscorp.com/documents/3061/curamik/Design-Rules---DBC-Technology.pdf [gefunden am 2019-04-24]**

**Beschreibung**

Die vorliegende Erfindung betrifft ein Metall-Keramik-Substrat für elektrische, insbesondere elektronische, Bauteile und ein Verfahren zum Herstellen eines Metall-Keramik-Substrats.

Metall-Keramik-Substrate sind beispielsweise als Leiterplatten oder Platinen aus dem Stand der Technik hinlänglich bekannt. Typischerweise werden auf einer Bauteilseite des Metall-Keramik-Substrats Anschlussflächen für elektrische Bauteile und Leiterbahnen angeordnet, wobei die elektrischen Bauteile und die Leiterbahnen zu elektrischen Schaltkreisen zusammenschaltbar sind. Wesentliche Bestandteile der Metall-Keramik-Substrate sind eine Isolationsschicht, die aus einer Keramik gefertigt ist, und eine an die Isolationsschicht angebundene Metallisierungsschicht. Wegen ihren vergleichsweise hohen Isolationsfestigkeiten haben sich aus Keramik gefertigte Isolationsschichten als besonders vorteilhaft erwiesen. Durch eine Strukturierung der Metallisierungsschicht können sodann Leiterbahnen und/oder Anschlussflächen für die elektrischen Bauteile realisiert werden.

Aus der WO 2017 056 666 A1 ist eine $Si_3N_4$-Isolationsschicht mit einer zweiseitigen Metallisierungsschicht bekannt, wobei die $Si_3N_4$-Isolationsschicht dünner als 0,26 mm ist und die Metallisierungsschichten dicker als 0,6 mm dimensioniert sind.

Die Broschüre "Curamik ceramic substrate - DBC technology - Design rules" (April 2014) beschreibt ein Metall-Keramik-Substrat umfassend eine zwischen zwei Kupferschichten eingelegte Keramikschicht (z.B. "HPS" = mit 9% $ZrO_2$ dotiertes $Al_2O_3$), und offenbart eine Cu/HPS/Cu-Sandwichstruktur mit Dicken 0.5/0.25/0.5 mm. "Mismatch" der Kupferschichte wird begrenzt. "DCB"-Technologie ("Direct Copper Bonding") und Laserschneiden werden weiter erwähnt.

Grundsätzlich ist neben einem niedrigen Wärmewiderstand auch eine hohe Temperaturwechselbeständigkeit wünschenswert, die zur Langlebigkeit des entsprechenden Metall-Keramik-Substrats beiträgt.

Ausgehend von diesem Hintergrund macht es sich die vorliegende Erfindung zur Aufgabe, ein Metall-Keramik-Substrat mit einem niedrigen Wärmewiderstand und einer vergleichsweise hohen Temperaturwechselbeständigkeit bereitzustellen.

Diese Aufgabe wird gelöst durch ein Metall-Keramik-Substrat gemäß Anspruch 1 und ein Verfahren gemäß Anspruch 9. Weitere Vorteile und Merkmale der Erfindung ergeben sich aus den Unteransprüchen sowie der Beschreibung und den beigefügten Figuren.

Erfindungsgemäß ist ein Metall-Keramik-Substrat vorgesehen, umfassend

- eine Keramik aufweisende Isolationsschicht mit einer ersten Dicke, und
- eine an der Isolationsschicht angebundene Metallisierungsschicht mit einer zweiten Dicke,

wobei die zweite Dicke größer als 200 $\mu$m und die erste Dicke kleiner als 200 $\mu$m ist, wobei die erste Dicke und die zweite Dicke derart dimensioniert sind, dass ein Verhältnis

- eines Betrages der Differenz zwischen einem thermischen Ausdehnungskoeffizienten der Metallisierungsschicht und einem thermischen Ausdehnungskoeffizienten des Metall-Keramik-Substrats zum

- thermischen Ausdehnungskoeffizient des Metall-Keramik-Substrats

einen Wert kleiner als 0,25, bevorzugt kleiner als 0,2 und besonders bevorzugt kleiner als 0,15, oder sogar kleiner als 0,1 annimmt.

Gegenüber dem Stand der Technik ist es mit der erfindungsgemäßen Ausgestaltung bzw. Dimensionierung der ersten Dicke und der zweiten Dicke mit Vorteil möglich, eine verbesserte Temperaturwechselbeständigkeit zu realisieren, insbesondere auch für solche Metall-Keramik-Substrate, deren Wärmewiderstand durch eine vergleichsweise dünne Isolationsschicht, d. h. mit einer ersten Dicke kleiner als 200 $\mu$m und bevorzugt kleiner als 150 $\mu$m, reduziert ist. Erfindungsgemäß werden hierbei zur Dimensionierung der ersten und/oder der zweiten Dicke der thermische Ausdehnungskoeffizient des Metall-Keramik-Substrats (d. h. des thermischen Gesamtausdehnungskoeffizienten, der alle Schichten, insbesondere die Isolationsschicht und die Metallisierungsschicht, berücksichtigt) und der thermische Ausdehnungskoeffizient der Metallisierungsschicht herangezogen. Es hat sich dabei überraschenderweise herausgestellt, dass sich trotz der vergleichsweise geringen ersten Dicken der Isolationsschicht die Temperaturwechselbeständigkeit verbessern lässt, sofern die zweite Dicke bzw. erste Dicke anspruchsgemäß dimensioniert werden. Insbesondere hat sich gezeigt, dass ein Ausfall eines Metall-Keramik-Substrats unter Temperaturwechseln umso geringer ist, desto kleiner die Differenz zwischen dem thermischen Ausdehnungskoeffizienten der Metallisierungsschicht und dem thermischen Ausdehnungskoeffizienten des Metall-Keramik-Substrats ist.

Ein weiterer Vorteil neben dem reduzierten Wärmewiderstand der vergleichsweise dünnen Isolationsschicht ist darin zu sehen, dass mit abnehmender Schichtdicke auch die Anzahl und Größe von Gefügefehlern sinkt. Entsprechend nimmt auch eine Wahrscheinlichkeit für das Versagen der eine Keramik aufweisenden Isolationsschicht ab. Die erste Dicke und die zweite Dicke werden dabei entlang einer senkrecht zur Haupterstreckungsebene verlaufenden Richtung bemessen, wobei die Haupterstreckungsebene parallel zur Isolationsschicht verläuft. Die Metallisierungsschicht ist dabei über eine Anbindungsfläche unmittelbar an die Isolationsschicht angebunden.

Als Temperaturwechselbeständigkeit wird vorzugsweise ein Einreißen der Isolationsschicht im Grenzbereich zu der Metallisierungsschicht verstanden. Dieses Einreißen führt wiederum mit steigender Zykluszahl zu einer Delamination. Die unter Temperaturwechseln beobachtbare Lebensdauer des Metall-Keramik-Substrats endet dabei, wenn mittels US-Mikroskopie ein Riss nachweisbar ist, der wiederum den Wärmeabtransport unterhalb der Wärmequellen bzw. im Bereich der halben Kupferdicke um die Wärmequelle herum behindert bzw. die Isolationsfestigkeit des Substrates einschränkt. Es hat sich herausgestellt, dass die unter Temperaturwechsel beobachte Lebensdauer verlängert werden kann, wenn das Metall-Keramik-Substrat anspruchsgemäß dimensioniert wird.

Vorzugsweise weist die Isolationsschicht $Al_2O_3$, $Si_3N_4$, AlN, eine HPSX-Keramik (d. h. eine Keramik mit einer $Al_2O_3$- Matrix, die einen x-prozentigen Anteil an $ZrO_2$ umfasst, beispielsweise $Al_2O_3$ mit 9% $ZrO_2$ = HPS9 oder $Al_2O_3$ mit 25% $ZrO_2$ = HPS25), SiC, BeO, MgO, hochdichtes MgO (> 90% der theoretischen Dichte), TSZ (tetragonal stabilisiertes Zirkonoxid) oder ZTA als Material für die Keramik auf. Es ist dabei auch vorstellbar, dass die Isolationsschicht als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einer Isolationsschicht zusammengefügt sind. Als Materialien für die Metallisierungsschicht sind Kupfer, Aluminium, Molybdän und/oder deren Legierungen, sowie Laminate wie CuW, CuMo, CuAl, AlCu und/oder CuCu, insbesondere eine Kupfersandwichstruktur mit einer ersten Kupferschicht und einer zweiten Kupferschicht, wobei sich eine Korngröße in der ersten Kupferschicht von einer zweiten Kupferschicht unterscheidet, vorstellbar.

Weiterhin ist es vorstellbar, dass die Isolationsschicht zum Beispiel zirkoniaverstärktes Aluminiumoxid umfasst, was mit Vorteil die Stabilität der Isolationsschicht erhöht, während beispielsweise eine Isolationsschicht aus $Al_2O_3$ vergleichsweise günstig produzierbar ist.

Beispielsweise weist eine Isolationsschicht aus der Keramik HPS9 eine erste Dicke kleiner als 0,26 mm oder 0,32 mm auf, wenn die zweite Dicke der aus Kupfer gefertigten Metallisierungsschicht einen Wert von im Wesentlichen 0,6 mm annimmt.

Gemäß einer weiteren Ausführungsform der vorliegenden Erfindung ist es vorgesehen, dass die erste Dicke größer als 30 μm, bevorzugt größer als 60 μm und besonders bevorzugt größer als 90 μm ist. Es hat sich herausgestellt, dass solche ersten Dicken eine entsprechende Isolationsfestigkeit und Stabilität des Metall-Keramik-Substrats sicherstellen können. Zudem ist ein Fertigungsaufwand für Isolationsschichten mit einer ersten Dicke von mehr als 90 μm geringer als derjenige für dünner dimensionierte Isolationsschichten.

Vorzugsweise ist es vorgesehen, dass auf der der Metallisierungsschicht gegenüberliegenden Seite an der Isolationsschicht eine weitere Metallisierungsschicht mit einer dritten Dicke angebunden ist, wobei die erste Dicke, die zweite Dicke und/oder die dritte Dicke derart dimensioniert sind, dass ein Verhältnis

- eines Betrages der Differenz zwischen einem thermischen Ausdehnungskoeffizienten der weiteren Metallisierungsschicht und/oder der Metallisierungsschicht und einem thermischen Ausdehnungskoeffizienten des Metall-Keramik-Substrats zum

- thermischen Ausdehnungskoeffizienten des Metall-Keramik-Substrats

- einen Wert kleiner als 0,25, bevorzugt kleiner als 0,2 und besonders bevorzugt kleiner als 0,15, oder sogar kleiner als 0,1 annimmt.

Vorzugsweise ist das Metall-Keramik-Substrat thermomechanisch symmetrisch ausgebildet. Insbesondere sind die Metallisierungsschicht, die Isolationsschicht und die weitere Metallisierungsschicht entlang einer senkrecht zur Haupterstreckungsebene verlaufenden Stapelrichtung übereinander angeordnet. Dabei bemisst sich die dritte Dicke in einer senkrecht zur Haupterstreckungsebene verlaufenden Richtung. Vorzugsweise wird der thermische Ausdehnungskoeffizient der weiteren Metallisierungsschicht oder der Metallisierungsschicht ausgewählt, der näher am thermischen Ausdehnungskoeffizienten des Metall-Keramik-Substrats liegt. Für den Fachmann ist es ersichtlich, dass die formulierten Bedingungen auf Metall-Keramik-Substrate übertragbar sind, die aus mehr als drei Schichten zusammengesetzt sind. Vorzugsweise lässt sich ein solches mehrschichtiges Metall-Keramik-Substrat mit mehr als drei Schichten auf ein Metall-Keramik-Substrat mit einer Isolationsschicht, einer Metallisierungsschicht und einer weiteren Metallisierungsschicht übertragen, d. h. ein dreischichtiges Metall-Keramik-Substrat. Vorzugsweise ist das Material für die zweite Metallisierungsschicht derart gewählt, dass es die Steifigkeit des gesamten Metall-Keramik-Substrats erhöht. Dadurch lässt sich gezielt die mechanische Belastbarkeit des gesamten Metall-Keramik-Substrats anpassen. Es ist dabei vorstellbar, dass sich hierzu das Material für die erste Metallisierungsschicht von dem Metall der zweiten Metallisierungsschicht unterscheidet. Beispielsweise handelt es sich bei dem Material für die weitere Metallisierungsschicht um Molybdän. Als Materialien für die weiteren Metallisierungsschicht sind ebenfalls Kupfer, Aluminium, Wolfram, und/oder deren Legierungen, sowie Laminate wie CuW, CuMo, CuAl, AlCu und/oder CuCu, insbesondere eine Kupfersandwichstruktur mit einer ersten Kupferschicht und einer zweiten Kupferschicht, wobei sich eine Korngröße in der ersten Kupferschicht von einer zweiten Kupferschicht unterscheidet, vorstellbar. Desweiteren sind auch Rückseitenmetallisierungen auf Basis von MMC's wie z.B. CuSiC, CuC, AlSiC oder MgSiC denkbar, deren CTE insbesondere an den kombinierten CTE des Substrates und/oder den Chip angepasst werden kann. Besonders bevorzugt ist es vorgesehen, dass die weitere Metallisierungsschicht zwischen 1,1 und 10 mal so dick ist, vorzugsweise zwischen 1,5 und 8 und besonders bevorzugt zwischen 2 und 6 mal so dick ist wie die Metallisierungsschicht.

Vorzugsweise ist die weitere Metallisierungsschicht zur Stabilisierung frei von Unterbrechungen, insbesondere frei von Isolationsgräben. Dadurch lässt sich vermeiden, dass das Metall-Keramik-Substrat im Bereich der Isolationsgräben nur von der dünnen Isolationsschicht gebildet wird und entsprechend anfällig für einen Bruch in diesem Bereich ist. Mit anderen Worten: die weitere Metallisierungsschicht dient als Stabilisierungsschicht für die vergleichsweise dünne Isolationsschicht. Es ist auch vorstellbar, dass die Metallisierung und die weitere Metallisierung derart gestaltet sind, dass entlang der Stapelrichtung Isolationsgräben in der Metallisierungsschicht und die Isolationsgräben in der weiteren Metallisierungsschicht nicht übereinander angeordnet sind. Es hat sich zudem herausgestellt, dass sich trotz der asymmetrischen Ausgestaltung der weiteren Metallisierungsschicht und der Metallisierungsschicht vergleichsweise große Lebensdauern realisieren lassen. Vorzugsweise erstreckt sich die weitere Metallisierungsschicht in einer parallel zur Haupterstreckungsebene verlaufenden Richtung weiter als die Metallisierungsschicht. D. h. wie weitere Metallisierungsschicht ragt in einer parallel zur Haupterstreckungsebene verlaufenden Richtung gegenüber der Metallisierungsschicht vor. Denkbar ist auch, dass die weitere Metallisierungsschicht dicker ist als die Metallisierungsschicht, um für eine ausreichende Stabilität des Metall-Keramik-Substrats zu sorgen. Mit anderen Worten: Mittels der dickeren weiteren Metallisierungssicht wird die reduzierte Dicke der Isolationsschicht zumindest teilweise kompensiert.

In einer weiteren Ausführungsform der vorliegenden Erfindung ist es vorgesehen, dass die zweite Dicke und/oder dritte Dicke größer als 300 μm und besonders bevorzugt größer als 500 μm ist. Die gegenüber der ersten Dicke größer dimensionierte zweite Dicke der Metallisierungsschicht dient mit Vorteil zur Begrenzung der Erwärmung der Leiterbahnen durch ohmsche Verluste bei einer Stromleitung ,zur Wärmespreizung unterhalb der Wärmequellen und zur Minimierung eines Durchbiegens des Metall-Keramik-Substrats. Dies kann insbesondere für Dicken oberhalb von 500 μm für eine Mehrheit der verschiedenen Metallisierungsschichten sichergestellt werden.

Vorzugsweise hängt der thermische Ausdehnungskoeffizient von materialspezifischen Parametern und/oder einer Poissonzahl ab. Beispielsweise hängt der thermische Ausdehnungskoeffizient von einem Elastizitätsmodul, der Poissonzahl und/oder einen materialspezifischen, thermischen Ausdehnungskoeffizienten ab. Insbesondere gilt der Zusammenhang

$$CTE = \frac{\sum_{i=1}^{n} CTE_i \cdot \frac{E_i}{(1-\eta_i)} \cdot Di}{\sum_{i=1}^{n} \cdot \frac{E_i}{(1-\eta_i)} \cdot Di},$$

wobei $Di$ die i-te Dicke von n Schichten mit dem jeweiligen materialspezifischen, thermischen Ausdehnungskoeffizienten $CTE_i$ bezeichnet. Zudem wird mittels der Poissonzahl $\eta_i$ die Form der jeweiligen Schicht sowie deren E-Modul $E_i$ berücksichtigt. Mittels dieses Zusammenhangs lässt sich auf Grundlage von materialspezifischen Größen und Dimensionierungsangaben der jeweilige thermische Ausdehnungskoeffizient bestimmen, wodurch ein Vergleich zwischen den jeweiligen thermischen Ausdehnungskoeffizienten möglich ist.

Zweckmäßigerweise stimmen die zweite Dicke und die dritte Dicke im Wesentlichen überein. Vorzugsweise sind die Metallisierungsschicht und die weitere Metallisierungsschicht aus demselben Material gefertigt. Es ist auch vorstellbar, dass die dritte Dicke und/oder die Materialwahl der weiteren Metallisierungsschicht angepasst sind, um eine gewünschte Größendimensionierung der Metallisierungsschicht und der Isolationsschicht zu realisieren.

Ein anderer Aspekt der vorliegenden Erfindung ist ein Verfahren zum Herstellen eines Metall-Keramik-Substrats, umfassend

- Bereitstellen einer Isolationsschicht, die eine Keramik aufweist, mit einer ersten Dicke und

- Bereitstellen einer an der Isolationsschicht angebundenen Metallisierungsschicht mit einer zweiten Dicke und

- Anbinden der Metallisierungsschicht an die Isolationsschicht

wobei die erste Dicke und/oder die zweite Dicke derart dimensioniert werden, dass ein Verhältnis

• eines Betrags der Differenz zwischen einem thermischen Ausdehnungskoeffizienten der Metallisierungsschicht und einem thermischen Ausdehnungskoeffizienten des Metall-Keramik-Substrats zum

• thermischen Ausdehnungskoeffizient des Metall-Keramik-Substrats

einen Wert kleiner als 0,25 bevorzugt kleiner als 0,2 und besonders bevorzugt kleiner als 0,15 oder sogar kleiner als 0,1 annimmt.

Alle für das erfindungsgemäße Metall-Keramik-Substrat beschriebenen Merkmale und deren Vorteile lassen sich sinngemäß ebenfalls auf das erfindungsgemäße Verfahren übertragen und vice versa. Vorzugsweise ist es vorgesehen, dass man bei der Bestimmung der ersten Dicke, der zweiten Dicke und/oder der dritten Dicke zunächst von einer gewünschten Gesamtdicke des Metall-Keramik-Substrats ausgeht. Anschließend legt man die bevorzugt zweite Dicke und/oder erste Dicke fest, um anschließend anhand der thermischen Ausdehnungskoeffizienten die erste Dicke, die zweite Dicke und ggf. die dritte Dicke festzulegen.

Gemäß einer bevorzugten Ausführungsform der vorliegenden Erfindung ist es vorgesehen, dass die Metallisierungsschicht mittels eines DCB-Verfahrens oder eines Aktivlötverfahrens an die Isolationsschicht angebunden wird.

Unter einem "DCB-Verfahren" (Direct-Copper-Bond-Technology) bzw. DAB-Verfahren" (Direct-Aluminium -Bond-Technology) versteht der Fachmann ein solches Verfahren, das beispielsweise zum Verbinden von Metallschichten oder -blechen (z. B. Kupferblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht) aufweisen. Bei diesem beispielsweise in der US 3 744 120 A oder in der DE23 19 854 C2 beschriebenen Verfahren bildet diese Schicht oder dieser Überzug (Aufschmelzschicht) ein Eutektikum mit einer Schmelztemperatur unter der Schmelztemperatur des Metalls (z. B. Kupfer), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Insbesondere weist das DCB-Verfahren dann z. B. folgende Verfahrensschritte auf:

- Oxidieren einer Kupferfolie derart, dass sich eine gleichmäßige Kupferoxidschicht ergibt;

- Auflegen der Kupferfolie auf die Keramikschicht;

- Erhitzen des Verbundes auf eine Prozesstemperatur zwischen etwa 1025 bis 1083°C, z. B. auf ca. 1071°C;

- Abkühlen auf Raumtemperatur.

Unter einem Aktivlot-Verfahren, z. B. zum Verbinden von Metallschichten oder Metallfolien, insbesondere auch von Kupferschichten oder Kupferfolien mit Keramikmaterial, ist ein Verfahren zu verstehen, welches speziell auch zum Herstellen von Metall-Keramik-Substraten verwendet wird. Hier wird bei einer Temperatur zwischen ca. 650-1000°C eine Verbindung zwischen einer Metallfolie, beispielsweise einer Kupferfolie, und einem Keramiksubstrat, beispielsweise Aluminiumnitrid-Keramik, unter Verwendung eines Hartlots hergestellt, welches zusätzlich zu einer Hauptkomponente wie Kupfer, Silber und/oder Gold, auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist.

Alternativ sind zur Anbindung auch ein DAB - Verfahren bei Aluminiummetallisierung und/oder ein Dickschichtverfahren bekannt.

Vorzugsweise ist es vorgesehen, dass die Metall-Keramik-Substrate mittels Laserritzen, Laserschneiden und/oder Wasserstrahlschneiden vereinzelt werden. Dadurch lassen sich die einzelnen Metall-Keramik-Substrate einfach und vergleichsweise schnell bereitstellen, nachdem sie in einem vorangegangenen Verfahren gemeinschaftlich ausgebildet wurden. Vorzugsweise werden die Metall-Keramik-Substrate mittels eines Schneidevorgangs, beispielsweise mittels Laserritzen, Laserschneidend und/oder Wasserstrahlschneiden realisiert, insbesondere aus einer Masterkarte, wenn die weitere Metallisierungsschicht frei von Unterbrechungen bzw. Durchätzungen ist. Dadurch wird ein erfolgreiches Vereinzeln gefördert bei den Substraten, die wegen der insbesondere durchgehenden weiteren Metallisierungsschicht nur aufwendig bzw. schwer durch Brechen vereinzelt werden können

Der Ausdruck im Wesentlichen bedeutet im Sinne der Erfindung Abweichungen vom jeweils exakten Wert um +/- 15 %, bevorzugt um +/- 10 % und besonders bevorzugt um +/- 5 % und/oder Abweichungen in Form von für die Funktion unbedeutenden Änderungen.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsform können dabei im Rahmen der Erfindung miteinander kombiniert werden.

Es zeigt:

Fig. 1:    Metall-Keramik-Substrat gemäß einer ersten bevorzugten Ausführungsform der vorliegenden Erfindung

Fig. 2    Metall-Keramik-Substrat gemäß einer zweiten bevorzugten Ausführungsform der vorliegenden Erfindung

Fig. 3    Metall-Keramik-Substrat gemäß einer dritten bevorzugten Ausführungsform der vorliegenden Erfindung und

Fig. 4 :    schematisch in einem Flussdiagramm für ein Verfahren zur Herstellung eines Metall-Keramik-Substrat gemäß einer bevorzugten Ausführungsform der vorliegende Erfindung

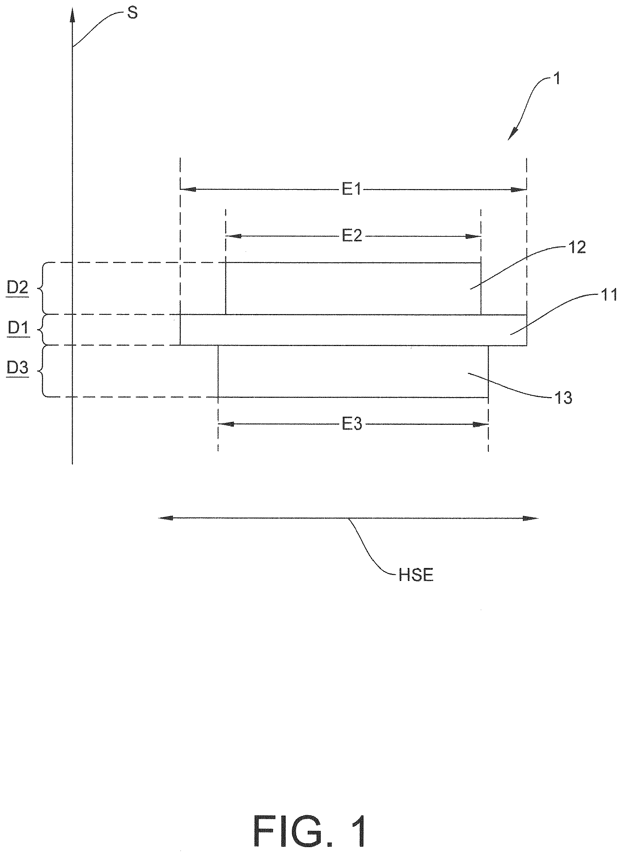

In **Figur 1** ist ein Metall-Keramik-Substrat 1 gemäß einer bevorzugten Ausführungsform der vorliegenden Erfindung dargestellt. Solche Metall-Keramik-Substrate 1 dienen vorzugsweise als Träger von elektronischen bzw. elektrischen Bauteile, die an das Metall-Keramik-Substrat 1 anbindbar sind. Wesentliche Bestandteile eines solchen Metall-Keramik-Substrats 1 sind eine sich entlang einer Haupterstreckungsebene HSE erstreckende Isolationsschicht 11 und eine an die Isolationsschicht 11 angebundene Metallisierungsschicht 12. Die Isolationsschicht 11 ist aus mindestens einem eine Keramik umfassenden Material gefertigt. Die Metallisierungsschicht 12 und die Isolationsschicht 11 sind dabei entlang einer senkrecht zur Haupterstreckungsebene HSE verlaufenden Stapelrichtung S übereinander angeordnet.

Dabei weist die Isolationsschicht 11 eine senkrecht zur Haupterstreckungsebene HSE bzw. parallel zur Stapelrichtung S bemessene erste Dicke D1 und eine parallel zur Haupterstreckungsebene HSE bemessene erste Erstreckung E1 auf und die Metallisierungsschicht 12 eine senkrecht zur Haupterstreckungsebene HSE bzw. parallel zur Stapelrichtung S bemessene zweite Dicke D2 und eine parallel zur Haupterstreckungsebene HSE bemessene zweite Erstreckung E2 auf. In einer parallel zur Stapelrichtung S verlaufenden Richtung ist bevorzugt auf der der Metallisierungsschicht 12 gegenüberliegenden Seite der Isolationsschicht 11 eine weitere Metallisierungsschicht 13 an die Isolationsschicht 12 angebunden. Die weitere Metallisierungsschicht 13 weist dabei eine senkrecht zur Haupterstreckungsebene HSE bzw. parallel zur Stapelrichtung S bemessene dritte Dicke D3 und eine parallel zur Haupterstreckungsebene HSE bemessene dritte erste Erstreckung E3 auf. Die Metallisierungsschicht 12 und/oder die weitere Metallisierungsschicht 13 sind vorzugsweise strukturiert, beispielsweise mittels Ätzen oder Oberflächenfräsen strukturiert, um beispielsweise mittels der strukturierten Metallisierungsschicht 12 Leiterbahnen und/oder Anschlussflächen für elektrische Schaltkreise bereitzustellen.

Zur Reduktion des Wärmewiderstands ist es bevorzugt vorgesehen, dass das Metall-Keramik-Substrat 1 eine Isolationsschicht 11 mit einer ersten Dicke D1 von weniger als 200 μm aufweist, während die zweite Dicke D2 der Metallisierungsschicht 12 und/oder die dritte Dicke D3 der weiteren Metallisierungsschicht 13 einen Wert von mehr als 200 μm, besonders bevorzugt von mehr als 500 μm, annimmt. Mit anderen Worten: Es ist vorgesehen, dass die Isolationsschicht 11 jeweils dünner ist als die Metallisierungsschicht 12 und die weitere Metallisierungsschicht 13. Dabei hat sich eine vergleichsweise dünne Isolationsschicht 11 als besonders vorteilhaft für einen niedrigen Wärmewiderstand herausgestellt.

Um einer Erwärmung der Leiterbahnen durch ohmsche Verluste während der Stromleitung entgegenzuwirken, sowie die Wärmespreizung zu verbessern und ein Durchbiegen des Metall-Keramik-Substrats 1 zu minimieren, werden die zweite Dicke D2 der Metallisierungsschicht 12 und/oder die dritte Dicke D3 der weiteren Metallisierungsschicht 13 entsprechend vergleichbar groß dimensioniert, d.h. bevorzugt größer als die erste Dicke D1 der Isolationsschicht 11. In der in Figur 1 dargestellten Ausführungsform ist die weitere Metallisierungsschicht 13 in einer senkrecht zur Haupterstreckungsebene HSE verlaufenden Richtung zumindest bereichsweise, vorzugsweise vollständig, deckungsgleich zur Metallisierungsschicht 12 angeordnet. Dabei erstreckt sich die weitere Metallisierungsschicht 13 in einer parallel zur Haupterstreckungsebene HSE verlaufenden Richtung weiter als die Metallisierungsschicht 12. Vorzugsweise nimmt ein Verhältnis der parallel zur Haupterstreckungsebene HSE bemessenen dritten Erstreckung E3 der weiteren Metallisierungsschicht 13 zu der parallel zur Haupterstreckungsebene HSE bemessenen zweiten Erstreckung E2 der Metallisierungsschicht 12 einen Wert zwischen 1,01 und 1,4 , bevorzugt zwischen 1,01 und 1,2-mal und besonders bevorzugt zwischen 1,05 und 1,15 annimmt. Die Metallisierungsschicht 12 kann dabei ihrerseits durch schaltungsbedingte Strukturen unterbrochen sein kann.

Die Lebensdauer des Metall-Keramik-Substrats 1 wird maßgeblich durch dessen Temperaturwechselbeständigkeit bestimmt. Es hat sich dabei gezeigt, dass es bei geringen ersten Dicken D1 der Isolationsschicht 11 mit Vorteil möglich ist, über die Dimensionierung der ersten Dicke D1 der Isolationsschicht 11 sowie der zweiten Dicke D2 der Metallisierungsschicht 12 und der dritten Dicke D3 der weiteren Metallisierungsschicht 13 die Temperaturwechselbeständigkeit zu optimieren. Hierbei ist es bevorzugt vorgesehen, dass die erste Dicke D1, die zweite Dicke D2 und/oder die dritte Dicke D3 derart eingestellt werden, dass ein Verhältnis

-　eines Betrag der Differenz zwischen einem thermischen Ausdehnungskoeffizient der Metallisierungsschicht 12 bzw. der weiteren Metallisierungsschicht 13 und einem thermischen Ausdehnungskoeffizienten des Metall-Keramik-Substrats 1 zum

-　thermischen Ausdehnungskoeffizient des Metall-Keramik-Substrats 1

einen Wert kleiner als 0,25 bevorzugt kleiner als 0,2 und besonders bevorzugt kleiner als 0,15 oder sogar kleiner als 0,1 annimmt.

Dabei wird zur Bestimmung des thermischen Ausdehnungskoeffizienten des Metall-Keramik-Substrats 1, der ersten Metallisierungsschicht 12 bzw. der zweiten Metallisierungsschicht 13 folgender Zusammenhang herangezogen:

$$CTE = \frac{\sum_{i=1}^{n} CTE_i \cdot \frac{E_i}{(1-\eta_i)} \cdot Di}{\sum_{i=1}^{n} \cdot \frac{E_i}{(1-\eta_i)} \cdot Di},$$

wobei *Di* die i-te Dicke von n Schichten mit dem jewei-

ligen $CTE_i$ bezeichnet. Zudem wird mittels der Poissonzahl $\eta_i$ die Form der jeweiligen Schicht sowie deren E-Modul $E_i$ berücksichtigt.

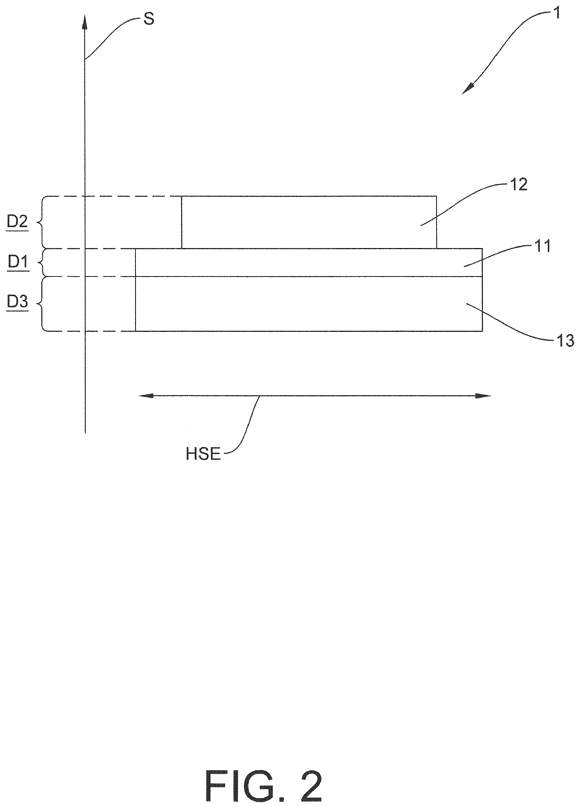

In Figur 2 ist ein Metall-Keramik-Substrat 1 gemäß einer zweiten bevorzugten Ausführungsform der vorliegenden Erfindung dargestellt. Das Metall-Keramik-Substrat 1 aus der Figur 2 unterscheidet sich dabei im Wesentlichen nur dahingehend von dem aus der Figur 1, als dass sich die weitere Metallisierungsschicht 13 entlang der gesamten Ausdehnung, d.h. der ersten Erstreckung E1 der Isolationsschicht 11 erstreckt. Mit anderen Worten: die weitere Metallisierungsschicht 13 schließt in einer parallel zur Haupterstreckungsebene HSE verlaufenden Richtung bündig mit der Isolationsschicht 11, vorzugsweise zu allen Seiten hin, ab, d.h. die erste Erstreckung E1 ist gleich der dritten Erstreckung E3. Es ist aber auch vorstellbar, dass die zweite Erstreckung E2 der Metallisierungsschicht 12 entlang der Haupterstreckungsebene HSE größer ist als die dritte Erstreckung E3 der weiteren Metallisierungsschicht 13, ohne dass die weitere Metallisierungsschicht 13 bündig mit der Isolationsschicht 11 abschließt. Beispielsweise ist es vorstellbar, dass die weitere Metallisierungsschicht 13 in einer parallel zur Haupterstreckungsebene HSE verlaufenden Richtung gegenüber der Metallisierungsschicht 12 vorsteht, vorzugsweise um einen Abstand, der kleiner, größer oder gleich ist der Distanz zwischen einem äußersten Umfang der Isolationsschicht 11 und einem äußersten Umfang der Metallisierungsschicht 12 in derselben Richtung.

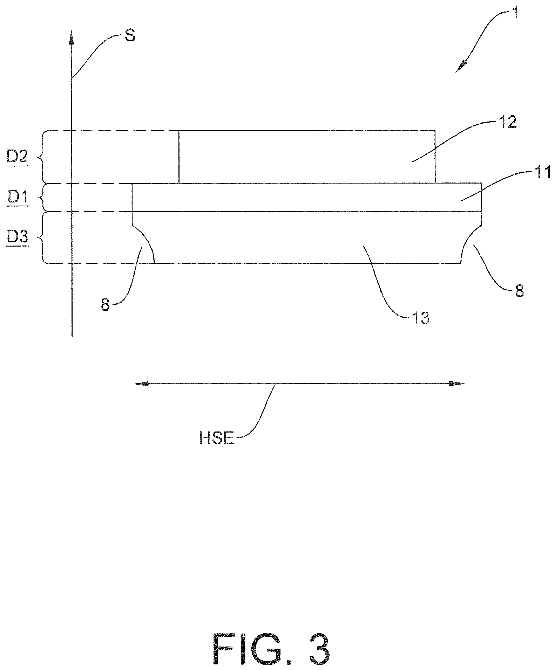

In Figur 3 ist ein Metall-Keramik-Substrat 1 gemäß einer dritten bevorzugten Ausführungsform der vorliegenden Erfindung dargestellt. Das Metall-Keramik-Substrat 1 aus der Figur 3 unterscheidet sich dabei im Wesentlichen nur dahingehend von dem aus der Figur 2, als dass die weitere Metallisierungsschicht 13 eine Aussparung, Schwächung oder Dickenverjüngung 8, insbesondere auf ihrer der Isolationsschicht 11 abgewandten Seite aufweist. Vorzugsweise ist die Aussparung 8 im Randbereich der weiteren Metallisierungsschicht 13 vorgesehen. Beispielsweise ist die Aussparung 8 in die weitere Metallisierungsschicht 13 eingeätzt.

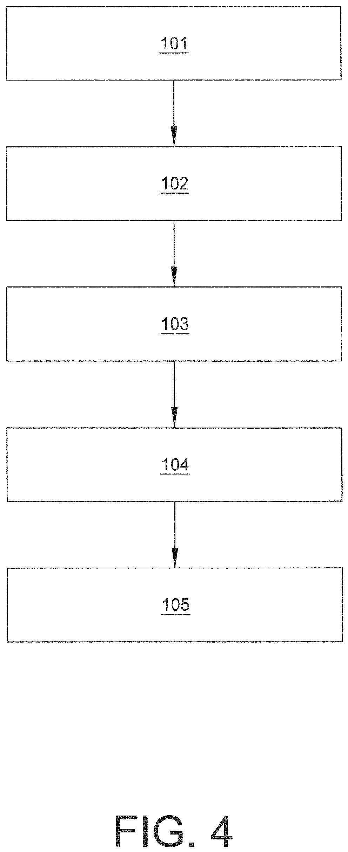

In Figur 4 ist schematisch in einem Flussdiagramm ein Verfahren zur Herstellung eines Metall-Keramik-Substrats 1 illustriert. Vorzugsweise ist es beispielsweise vorgesehen, dass eine Isolationsschicht 11 mit einer ersten Dicke D1 bereitgestellt wird, wobei die erste Dicke D1 der Isolationsschicht 11 kleiner ist als 200 μm. Im Anschluss an das Bereitstellen 101 bzw. Festlegen der Isolationsschicht 11 wird vorzugsweise unter Verwendung des oben näher bezeichneten Zusammenhangs mit dem $CTE_i$ für die Metallisierungsschicht 12 und/oder der weiteren Metallisierungsschicht 13 sowie dessen E-Modul und Poissonzahl, eine zweite Dicke D2 derart bestimmt bzw. festgelegt, dass ein Verhältnis zwischen

- eines Betrages der Differenz zwischen einem thermischen Ausdehnungskoeffizient der Metallisierungsschicht 12 bzw. der weiteren Metallisierungsschicht 13 und einem thermischen Ausdehnungskoeffizienten des Metall-Keramik-Substrats 1 zum

- thermischen Ausdehnungskoeffizient des Metall-Keramik-Substrats 1

einen Wert kleiner als 0,25, bevorzugt kleiner als 0,2, und besonders bevorzugt kleiner als 0,15 oder sogar kleiner als 0,1 annimmt. Nach dem Bestimmen 102 wird eine Metallisierungsschicht 12 mit der zweiten Dicke D2 an die Isolationsschicht 11 angebunden, vorzugsweise unter Verwendung eines Aktivlotverfahrens oder eines DAB-Verfahrens oder besonders bevorzugt eines DCB-Verfahrens.

Weiterhin ist es bevorzugt vorgesehen, dass neben der Metallisierungsschicht 11 eine weitere Metallisierungsschicht 13 mit der dritten Dicke D3 bei der Bestimmung der zweiten Dicke D2 berücksichtigt wird. Vorzugsweise ist es vorgesehen, dass nach dem Anbinden 103, was vorzugsweise zusammen mit dem Bestimmen 102 erfolgt, die Metall-Keramik-Substrate 1 mittels Laserritzen oder Laserschneiden vereinzelt werden und/oder die Metallisierungsschicht 11 beispielsweise durch einen Ätzprozess strukturiert wird; d.h. es folgt ein Vereinzeln 105 und/oder ein Strukturieren 104 des Metall-Keramik-Substrats 1. Vorzugsweise bleibt die weitere Metallisierungsschicht 13 strukturfrei, zumindest weist die weitere Metallisierungsschicht 13 keine durchgeätzten Strukturen auf, um die Stabilität des gesamten Metall-Keramik-Substrats 1 zu verbessern.

Bezugszeichenliste:

| | |
|---|---|
| 1 | Metall-Keramik-Substrat |
| 8 | Aussparung |
| 11 | Isolationsschicht |
| 12 | Metallisierungsschicht |
| 13 | weitere Metallisierungsschicht |
| E1 | erste Erstreckung |
| E2 | zweite Erstreckung |
| E3 | dritte Erstreckung |
| HSE | Haupterstreckungsebene |
| S | Stapelrichtung |
| D1 | erste Dicke |
| D2 | zweite Dicke |
| D3 | dritte Dicke |
| 101 | Bereitstellen einer Isolationsschicht |
| 102 | Bestimmen der zweiten Dicke |
| 103 | Anbinden |
| 104 | Strukturieren |
| 105 | Vereinzeln |

**Patentansprüche**

1. Metall-Keramik-Substrat (1), umfassend

    - eine Keramik aufweisende Isolationsschicht (11) mit einer ersten Dicke (D1) und
    - eine an der Isolationsschicht (11) angebundene Metallisierungsschicht (12) mit einer zweiten Dicke (D2),

    wobei die Metallisierungsschicht (12) mittels eines DCB-Verfahrens oder DAB-Verfahrens an die Isolationsschicht (11) angebunden ist wobei die erste Dicke (D1) kleiner als 200 $\mu$m und die zweite Dicke (D2) größer als 200 $\mu$m ist und wobei die erste Dicke (D1) und die zweite Dicke (D2) derart dimensioniert sind, dass ein Verhältnis

    -- eines Betrags der Differenz zwischen einem thermischen Ausdehnungskoeffizienten der Metallisierungsschicht (12) und einem thermischen Ausdehnungskoeffizienten des Metall-Keramik-Substrats (1) zum
    -- thermischen Ausdehnungskoeffizient des Metall-Keramik-Substrats (1) einen Wert kleiner als 0,25 bevorzugt kleiner als 0,2 und besonders bevorzugt kleiner als 0,15 oder sogar kleiner als 0,1 annimmt.

2. Metall-Keramik-Substrat (1) gemäß Anspruch 1, wobei die erste Dicke (D1) größer als 30 $\mu$m, bevorzugt größer als 60 $\mu$m und besonders bevorzugt größer als 90 $\mu$m ist.

3. Metall-Keramik-Substrat (1) gemäß einem der vorhergehenden Ansprüche, wobei auf der der Metallisierungsschicht (12) gegenüberliegenden Seite an der Isolationsschicht (11) eine weitere Metallisierungsschicht (13) mit einer dritten Dicke (D3) angebunden ist, wobei die erste Dicke (D1), die zweite Dicke (D2) und/oder die dritte Dicke (D3) derart dimensioniert sind, dass ein Verhältnis

    - eines Betrags der Differenz zwischen einem thermischen Ausdehnungskoeffizienten der weiteren Metallisierungsschicht (13) und/oder der Metallisierungsschicht (12) und einem thermischen Ausdehnungskoeffizienten des Metall-Keramik-Substrats (1) zum
    - thermischen Ausdehnungskoeffizienten des Metall-Keramik-Substrats (1) einen Wert kleiner als 0,25, bevorzugt kleiner als 0,2, und besonders bevorzugt kleiner als 0,15 oder sogar kleiner als 0,1 annimmt.

4. Metall-Keramik-Substrat (1) gemäß Anspruch 3, wobei zur Stabilisierung die weitere Metallisierungsschicht (13) frei von Unterbrechungen, insbesondere frei von Isolationsgräben, ist.

5. Metall-Keramik-Substrat (1) gemäß einem der vorhergehenden Ansprüche, wobei die zweite Dicke (D2) und/oder dritte Dicke (D3) größer als 300 $\mu$m, bevorzugt größer als 400 $\mu$m und besonders bevorzugt größer als 500 $\mu$m ist.

6. Metall-Keramik-Substrat (1) gemäß einem der vorhergehenden Ansprüche, wobei der thermische Ausdehnungskoeffizient von materialspezifischen Parametern und/oder einer Poissonzahl abhängt.

7. Metall-Keramik-Substrat (1) gemäß einem der Ansprüche 3 bis 5, wobei die zweite Dicke (D2) und die dritte Dicke (D3) im Wesentlichen übereinstimmen.

8. Metall-Keramik-Substrat (1) gemäß einem der vorhergehenden Ansprüche, wobei ein Verhältnis einer parallel zur Haupterstreckungsebene (HSE) bemessenen dritten Erstreckung (E3) der weiteren Metallisierungsschicht (13) zu einer parallel zur Haupterstreckungsebene (HSE) bemessenen zweiten Erstreckung (E2) der Metallisierungsschicht (12) einen Wert zwischen 1,01 und 1,4 annimmt.

9. Verfahren zum Herstellen eines Metall-Keramik-Substrats (1), umfassend

    - Bereitstellen einer Isolationsschicht (11), die eine Keramik aufweist, mit einer ersten Dicke (D1), wobei die erste Dicke (D1) kleiner als 200 $\mu$m ist,

        - Bereitstellen einer an der Isolationsschicht (11) angebundenen Metallisierungsschicht (12) mit einer zweiten Dicke (D2), wobei die zweite Dicke (D2) größer als 200 $\mu$m ist, und
        - Anbinden der Metallisierungsschicht (12) an die Isolationsschicht (11) wobei die erste Dicke (D1) und/oder die zweite Dicke (D2) derart dimensioniert werden, dass ein Verhältnis

        - eines Betrages der Differenz zwischen einem thermischen Ausdehnungskoeffizienten der Metallisierungsschicht (12) und einem thermischen Ausdehnungskoeffizienten des Metall-Keramik-Substrats (1) zum
        - thermischen Ausdehnungskoeffizienten des Metall-Keramik-Substrats (1) einen Wert kleiner als 0,25, bevorzugt kleiner als 0,2, und besonders bevorzugt kleiner als 0,15 oder sogar kleiner als 0,1 annimmt, **dadurch gekennzeichnet, dass** die Metallisierungsschicht (12) mittels eines DCB-Verfahrens oder DAB-Verfahrens an die Isolationsschicht (11) angebunden wird.

10. Verfahren gemäß Anspruch 9, wobei die Metall-Keramik-Substrate (1) mittels Laserritzen, Laserschneiden oder Wasserstrahlschneiden vereinzelt werden.

**Claims**

1. A metal-ceramic substrate (1) comprising

   - an isolation layer (11) comprising a ceramic and having a first thickness (D1), and
   - a metallization layer (12) bonded to the isolation layer (11) and having a second thickness (D2),

   wherein the metallization layer (12) is bonded to the isolation layer (11) by means of a DCB process or DAB process,
   wherein the first thickness (D1) is less than 200 $\mu$m and the second thickness (D2) is greater than 200 $\mu$m and wherein the first thickness (D1) and the second thickness (D2) are dimensioned such that a ratio of

   -- an amount of the difference between a thermal expansion coefficient of the metallization layer (12) and a thermal expansion coefficient of the metal-ceramic substrate (1) to
   -- the thermal expansion coefficient of the metal-ceramic substrate (1) has a value less than 0.25, preferably less than 0.2 and more preferably less than 0.15 or even less than 0.1.

2. The metal-ceramic substrate (1) according to claim 1, wherein the first thickness (D1) is greater than 30 $\mu$m, preferably greater than 60 $\mu$m and more preferably greater than 90 $\mu$m.

3. The metal-ceramic substrate (1) according to any one of the preceding claims, wherein on the side opposite the metallization layer (12), a further metallization layer (13) having a third thickness (D3) is bonded to the isolation layer (11), wherein the first thickness (D1), the second thickness (D2) and/or the third thickness (D3) are dimensioned such that a ratio of

   - an amount of the difference between a thermal expansion coefficient of the further metallization layer (13) and/or the metallization layer (12) and a thermal expansion coefficient of the metal-ceramic substrate (1) to
   - the thermal expansion coefficient of the metal-ceramic substrate (1) has a value less than 0.25, preferably less than 0.2, and more preferably less than 0.15 or even less than 0.1.

4. The metal-ceramic substrate (1) according to claim 3, wherein for stabilisation purposes the further metallisation layer (13) is free from interruptions, in particular free from isolation trenches.

5. The metal-ceramic substrate (1) according to any of the preceding claims, wherein the second thickness (D2) and/or third thickness (D3) is greater than 300 $\mu$m, preferably greater than 400 $\mu$m and more preferably greater than 500 $\mu$m.

6. The metal-ceramic substrate (1) according to any one of the preceding claims, wherein the thermal expansion coefficient depends on material-specific parameters and/or a Poisson's number.

7. The metal-ceramic substrate (1) according to any one of claims 3 to 5, wherein the second thickness (D2) and the third thickness (D3) are substantially the same.

8. The metal-ceramic substrate (1) according to any one of the preceding claims, wherein a ratio of a third extension (E3) of the further metallization layer (13) measured parallel to the main extension plane (HSE) to a second extension (E2) of the metallization layer (12) measured parallel to the main extension plane (HSE) has a value between 1.01 and 1.4.

9. A method for producing a metal-ceramic substrate (1) comprising

   - providing an isolation layer (11) comprising a ceramic having a first thickness (D1), wherein the first thickness (D1) is less than 200 $\mu$m,

     - providing a metallization layer (12) bonded to the isolation layer (11) and having a second thickness (D2), the second thickness (D2) being greater than 200 $\mu$m, and
     - bonding of the metallization layer (12) to the isolation layer (11)

   wherein the first thickness (D1) and/or the second thickness (D2) are dimensioned such that a ratio of

     - an amount of the difference between a thermal expansion coefficient of the metallization layer (12) and a thermal expansion coefficient of the metal-ceramic substrate (1) to
     - the thermal expansion coefficient of the metal-ceramic substrate (1)

has a value less than 0.25, preferably less than 0.2, and more preferably less than 0.15 or even less than 0.1, **characterized in that** the metallization layer (12) is bonded to the isolation layer (11) by means of a DCB process or DAB process.

10. The method according to claim 9, wherein the metal-ceramic substrates (1) are separated by means of laser scribing, laser cutting or water jet cutting.

## Revendications

1. Substrat métallo-céramique (1) comprenant

   - une couche d'isolation (11) comprenant de la céramique et ayant une première épaisseur (D1), et
   - une couche de métallisation (12) liée à la couche d'isolation (11) et ayant une seconde épaisseur (D2),

   dans lequel
   la couche de métallisation (12) est liée à la couche d'isolation (11) au moyen d'un procédé DCB ou d'un procédé DAB,
   la première épaisseur (D1) est inférieure à 200 $\mu$m et la seconde épaisseur (D2) est supérieure à 200 $\mu$m,
   et la première épaisseur (D1) et la seconde épaisseur (D2) sont dimensionnées de telle sorte qu'un rapport

   -- d'un montant de la différence entre un coefficient de dilatation thermique de la couche de métallisation (12) et un coefficient de dilatation thermique du substrat métallo-céramique (1) sur
   -- le coefficient de dilatation thermique du substrat métallo-céramique (1)

   prend une valeur inférieure à 0,25, de préférence inférieure à 0,2 et de manière particulièrement préférée inférieure à 0,15 ou même inférieure à 0,1.

2. Substrat métallo-céramique (1) selon la revendication 1,
   dans lequel la première épaisseur (D1) est supérieure à 30 $\mu$m, de préférence supérieure à 60 $\mu$m et de manière particulièrement préférée supérieure à 90 $\mu$m.

3. Substrat métallo-céramique (1) selon l'une des revendications précédentes, dans lequel une autre couche de métallisation (13) ayant une troisième épaisseur (D3) est liée à la couche d'isolation (11) sur le côté opposé à la couche de métallisation (12), la première épaisseur (D1), la seconde épaisseur (D2) et/ou la troisième épaisseur (D3) sont dimensionnées de telle sorte qu'un rapport

   - d'un montant de la différence entre un coefficient de dilatation thermique de l'autre couche de métallisation (13) et/ou de la couche de métallisation (12) et un coefficient de dilatation thermique du substrat métallo-céramique (1) sur
   - le coefficient de dilatation thermique du substrat métallo-céramique (1)

   prend une valeur inférieure à 0,25, de préférence inférieure à 0,2, et de manière particulièrement préférée inférieure à 0,15 ou même inférieure à 0,1.

4. Substrat métallo-céramique (1) selon la revendication 3,
   dans lequel, pour la stabilisation, l'autre couche de métallisation (13) est exempte d'interruptions, en particulier exempte de tranchées d'isolation.

5. Substrat métallo-céramique (1) selon l'une des revendications précédentes, dans lequel la seconde épaisseur (D2) et/ou la troisième épaisseur (D3) est supérieure à 300 $\mu$m, de préférence supérieure à 400 $\mu$m et de manière particulièrement préférée supérieure à 500 $\mu$m.

6. Substrat métallo-céramique (1) selon l'une des revendications précédentes, dans lequel le coefficient de dilatation thermique dépend de paramètres spécifiques au matériau et/ou d'un coefficient de Poisson.

7. Substrat métallo-céramique (1) selon l'une des revendications 3 à 5,
   dans lequel la seconde épaisseur (D2) et la troisième épaisseur (D3) coïncident sensiblement.

8. Substrat métallo-céramique (1) selon l'une des revendications précédentes, dans lequel un rapport d'une troisième extension (E3), mesurée parallèlement au plan d'extension principale (HSE), de l'autre couche de métallisation (13) sur une seconde extension (E2), mesurée parallèlement au plan d'extension principale (HSE), de la couche de métallisation (12) prend une valeur comprise entre 1,01 et 1,4.

9. Procédé de fabrication d'un substrat métallo-céramique (1), consistant à :

   - fournir une couche d'isolation (11) comprenant une céramique et ayant une première épaisseur (D1), ladite première épaisseur (D1) étant inférieure à 200 $\mu$m,
   - fournir une couche de métallisation (12) liée à la couche d'isolation (11) et ayant une seconde épaisseur (D2), ladite seconde épaisseur (D2) étant supérieure à 200 μm, et
- lier la couche de métallisation (12) à la couche d'isolation (11),

dans lequel
la première épaisseur (D1) et/ou la seconde épaisseur (D2) sont dimensionnées de telle sorte qu'un rapport

- d'un montant de la différence entre un coefficient de dilatation thermique de la couche de métallisation (12) et un coefficient de dilatation thermique du substrat métallo-céramique (1) sur
- le coefficient de dilatation thermique du substrat métallo-céramique (1)

prend une valeur inférieure à 0,25, de préférence inférieure à 0,2, et de manière particulièrement préférée inférieure à 0,15 ou même inférieure à 0,1, **caractérisé en ce que** la couche de métallisation (12) est liée à la couche d'isolation (11) au moyen d'un procédé DCB ou d'un procédé DAB.

10. Procédé selon la revendication 9, dans lequel les substrats métallo-céramiques (1) sont individualisés par traçage au laser, par découpe au laser ou par découpe au jet d'eau.

FIG. 1

FIG. 2

FIG. 3

FIG. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2017056666 A1
- US 3744120 A
- DE 2319854 C2

**In der Beschreibung aufgeführte Nicht-Patentliteratur**

- *Curamik ceramic substrate - DBC technology - Design rules,* April 2014